# EUROPEAN PATENT APPLICATION

(11) **EP 3 490 063 A1**
(43) Date of publication of application: **29.05.2019**
(21) Application number: 18207926.9
(22) Date of filing: 23.11.2018
(51) Int. Cl.: H01Q 1/32, G01S 13/93, H01Q 15/08, H01Q 19/06, H01Q 15/14, H01Q 21/08

(54) **RADAR DEVICE**

(30) Priority: 27.11.2017 JP 2017226998; 11.10.2018 JP 2018192851
(71) Applicant: Panasonic Intellectual Property Management Co., Ltd., Osaka-shi, Osaka 540-6207 (JP)
(72) Inventor: SHIOZAKI, Ryosuke, Osaka-shi, Osaka 540-6207 (JP); YUI, Tomohiro, Osaka-shi, Osaka 540-6207 (JP); TAKAHASHI, Ken, Osaka-shi, Osaka 540-6207 (JP); KASHINO, Yuichi, Osaka-shi, Osaka 540-6207 (JP); SUZUKI, Kouji, Osaka-shi, Osaka 540-6207 (JP); SAITO, Noriaki, Osaka-shi, Osaka 540-6207 (JP); NAKAMURA, Shigeki, Osaka-shi, Osaka 540-6207 (JP)
(74) Representative: Grünecker Patent- und Rechtsanwälte PartG mbB

(57) **Abstract**

A radar device includes: an antenna unit including antenna elements arrayed along a direction intersecting a front direction in a circuit board, transmitting an electromagnetic wave upward of a board surface of the circuit board, and receiving a reflected wave of the electromagnetic wave; a reflection unit supported above the board surface of the circuit board in a housing, reflecting the electromagnetic wave transmitted from the antenna unit to change a traveling direction of the electromagnetic wave to the front direction, and reflecting the reflected wave from the front direction to change a traveling direction of the reflected wave to a direction toward the antenna unit; and a dielectric lens disposed in an aperture of the housing to extend along a direction in which the antenna elements are arrayed, and having a semi-cylindrical shape or a parabolic-cylindrical shape projecting in the front direction.

## Description

### BACKGROUND

### 1. Technical Field

The present disclosure relates to a radar device.

### 2. Description of the Related Art

A radar device has been known, which uses electromagnetic waves in a frequency band of millimeter-waves and microwaves to detect a position of an object (hereinafter also referred to as "target") without contact.

Such radar device is, for example, mounted in a vehicle and used for monitoring multiple directions including a front direction, front-side directions, and rear-side directions.

### SUMMARY

As such a radar device, a radar device mounted in a lateral direction, in which a circuit board on which an antenna unit is mounted is arranged parallel to a direction of transmitting electromagnetic waves, has been recently under consideration from the viewpoints of, for example, reducing a space for mounting the radar device and enhancing a degree of freedom in selecting a position for mounting the radar device.

For example, Japanese Unexamined Patent Application Publication (Translation of PCT Application) No. 2008-503904 (PTL 1) discusses a radar device mounted in a lateral direction and achieving wide-area detection of an object by radially disposing on a board multiple end-fire antennas facing in directions different from each other.

However, the radar device discussed in PTL 1 has a problem in that the azimuth resolution capability for detecting the object is insufficient because the directions of transmitting the electromagnetic waves are limited to the directions that the respective end-fire antennas face. The radar device disclosed in PTL 1 has also a problem in that it is difficult to achieve the antenna gain.

One non-limiting and exemplary embodiment provides a radar device that has a device configuration of being mounted in a lateral direction and achieves high antenna gain and high azimuth resolution capability.

In one general aspect, the techniques disclosed here feature a radar device, including: a housing that includes an aperture in a front direction as a transmitting direction of an electromagnetic wave; a circuit board that is disposed in the housing such that a board surface extends along the front direction; an antenna unit that includes multiple antenna elements being arrayed along a direction intersecting the front direction in the circuit board, and that transmits the electromagnetic wave upward of the board surface of the circuit board and receives a reflected wave of the electromagnetic wave; a reflection unit that is supported in the housing above the board surface of the circuit board and that reflects the electromagnetic wave transmitted from the antenna unit to change a traveling direction of the electromagnetic wave to the front direction and reflects the reflected wave from the front direction to change a traveling direction of the reflected wave to a direction toward the antenna unit; and a dielectric lens that is disposed in the aperture of the housing to extend along a direction in which the multiple antenna elements are arrayed, and that has a semi-cylindrical shape or a parabolic-cylindrical shape projecting in the front direction.

The radar device according to the present disclosure may have a device configuration of being mounted in a lateral direction and achieve high antenna gain and high azimuth resolution capability.

Additional benefits and advantages of the disclosed embodiments will become apparent from the specification and drawings. The benefits and/or advantages may be individually obtained by the various embodiments and features of the specification and drawings, which need not all be provided in order to obtain one or more of such benefits and/or advantages.

### BRIEF DESCRIPTION OF THE DRAWINGS

Fig. 1 is a diagram illustrating a radar device according to a first embodiment being disposed in a vehicle;
Fig. 2 is a side sectional view of the radar device according to the first embodiment;
Fig. 3 is a view of the radar device according to the first embodiment seen from above;
Fig. 4 is a block diagram illustrating a configuration of a signal processing IC of the radar device according to the first embodiment;
Fig. 5 is a side sectional view of a radar device according to a second embodiment;
Fig. 6 is a side sectional view of a radar device according to a third embodiment;
Fig. 7 is a side sectional view of a radar device according to a fourth embodiment;
Fig. 8 is a view of the radar device according to the fourth embodiment seen from above;
Fig. 9 is a side sectional view of a radar device according to a fifth embodiment;
Fig. 10 is a diagram illustrating an example of a position at which a radar device according to a sixth embodiment is mounted;
Fig. 11 is a side sectional view illustrating an example of a configuration of a radar device according to a seventh embodiment; and
Fig. 12 is a side sectional view illustrating an example of a configuration of a radar device according to the seventh embodiment.

### DETAILED DESCRIPTION

Embodiments of the present disclosure are described below with reference to accompanied drawings. In this description and the drawings, descriptions of constituents having substantially the same functions are not repeated by using the same reference signs.

In order to clarify positional relationships between the constituents, a common orthogonal coordinate system (X, Y, Z) based on a front direction in which a radar device transmits electromagnetic waves to the outside of the device (i.e., a direction as a target of object detection) is indicated throughout the drawings. Hereinafter, descriptions are given using an X-axis positive direction representing the front direction in which the radar device transmits the electromagnetic waves to the outside of the device (hereinafter abbreviated as "front direction"), a Y-axis positive direction representing a right side surface direction of the radar device, and a Z-axis positive direction representing an upward direction of the radar device (hereinafter abbreviated as "upward direction").

### (First Embodiment)

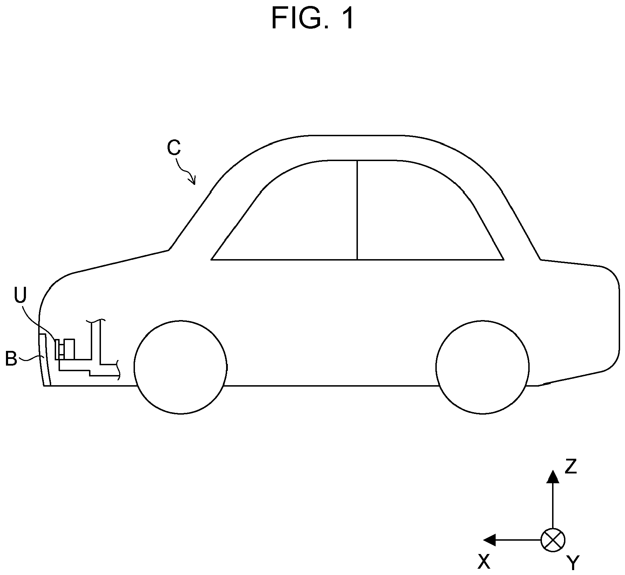

An example of a configuration of a radar device according to this embodiment is described with reference to Figs. 1 to 4. Hereinafter, a vehicle-mounted radar device is described as an example of a usage example of the radar device of the present disclosure.

Fig. 1 is a diagram illustrating a radar device U according to this embodiment disposed in a vehicle.

For example, the radar device U according to this embodiment is disposed in a cover member B (here, a bumper member B) of a vehicle C and performs transmission and reception of electromagnetic waves through the cover member B.

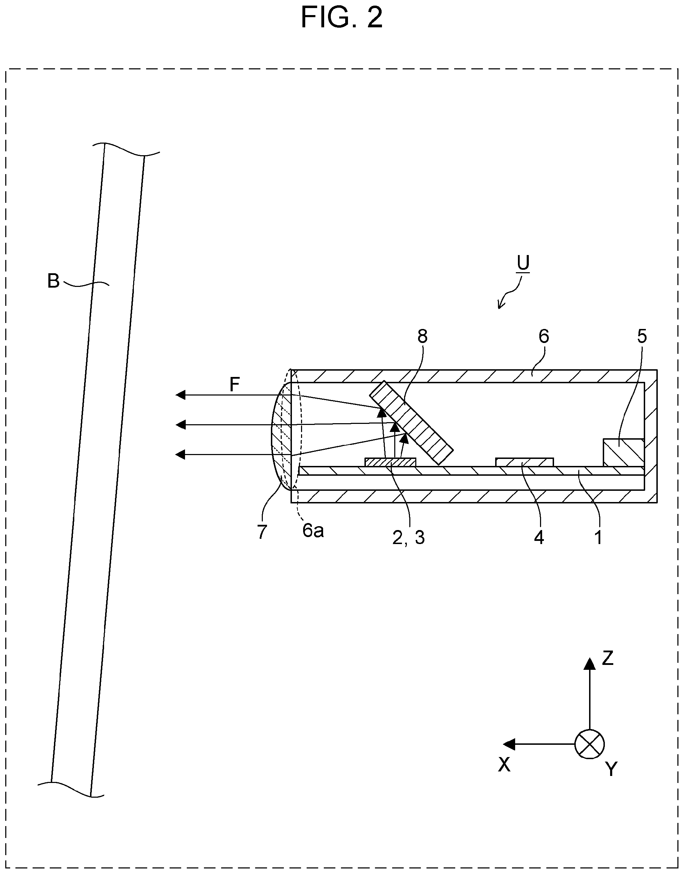

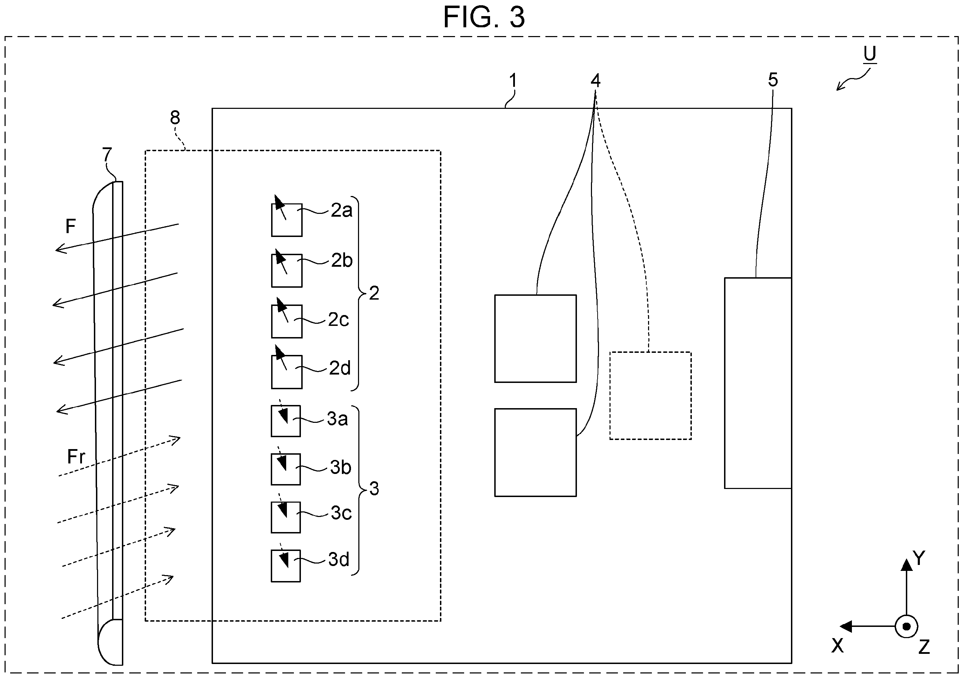

Fig. 2 is a side sectional view of the radar device U according to the first embodiment. Fig. 3 is a view of the radar device U according to the first embodiment seen from above.

Solid arrows F in Figs. 2 and 3 represent the electromagnetic waves transmitted by a transmitting antenna. Dotted line arrows Fr represent the reflected waves from the target. In Figs. 2 and 3, illustration of a structure supporting the radar device U in the vehicle C is omitted. In Fig. 3, illustration of a housing 6 is omitted. For the sake of convenience in describing, Fig. 3 illustrates an aspect where a dielectric lens 7 is viewed from an obliquely upward direction.

The radar device U according to this embodiment includes a circuit board 1, a transmitting antenna 2, a receiving antenna 3, signal processing ICs 4, a connector 5, a housing 6, a dielectric lens 7, and a reflection unit 8.

In the radar device U according to this embodiment, the circuit board 1 is disposed such that a board surface extends in a front-rear direction. The radar device U according to this embodiment transmits the electromagnetic waves upward from the transmitting antenna 2 disposed on the board surface of the circuit board 1, changes a traveling direction of the electromagnetic waves to a front direction using the reflection unit 8, and transmits the electromagnetic waves to the outside of the device.

In this embodiment, with such a configuration, the radar device U is disposed such that the extending direction of the board surface of the circuit board 1 intersects the extending direction of the cover member B (i.e., such that the cover member B and the antenna surface do not face each other), and thus a situation is inhibited where the reflected waves from the cover member B multiply reflect between the cover member B and the radar device U (e.g., circuit board 1, housing 6, and so on) and part of the reflected waves reaches the receiving antenna 3.

The circuit board 1 is a board on which the transmitting antenna 2, the receiving antenna 3, the signal processing ICs 4, the connector 5, and so on are mounted. The transmitting antenna 2, the receiving antenna 3, the signal processing ICs 4, the connector 5, and so on are mounted on a board surface of a front surface side or back surface side of the circuit board 1 while wiring (not illustrated) for electrically connecting these mounted parts (the transmitting antenna 2, the receiving antenna 3, the signal processing ICs 4, the connector 5, and so on) is patterned.

The circuit board 1 is disposed such that the board surface extends in the front-rear direction based on the front direction including a target region where the object is detected.

Material of the circuit board 1 is not specifically limited in the present disclosure; however, it is possible to use a printed circuit board (PCB), for example. Also, a multilayer board or a semiconductor board in which the signal processing ICs 4 are mounted may also be used as the circuit board 1. The circuit board 1 typically has a flat plate shape.

The transmitting antenna 2 is disposed on the board surface of the front or back surface side of the circuit board 1 and transmits the electromagnetic waves upward of the board surface. Likewise, the receiving antenna 3 is disposed on the board surface of the circuit board 1 and receives the reflected waves from above the board surface of the circuit board 1. In other words, the transmitting antenna 2 and the receiving antenna 3 have directivity characteristics of transmitting and receiving in a direction substantially normal to the board surface of the circuit board 1.

Note that "upward of the board surface of the circuit board 1" means a positive Z direction when the board surface is the front surface side of the circuit board 1 and means a negative Z direction when the board surface is the back surface side of the circuit board 1 (the same applies hereinafter). However, "upward of the board surface of the circuit board 1" as the facing directions of the transmitting antenna 2 and the receiving antenna 3 is a substantially positive Z direction or negative Z direction that may be angled in ±X direction or ±Y direction.

The transmitting antenna 2 and the receiving antenna 3 respectively include multiple antenna elements being arrayed along the Y-axis direction on the board surface of the circuit board 1 (in Fig. 3, the transmitting antenna 2 includes four antenna elements 2a, 2b, 2c, and 2d disposed along the Y-axis direction and the receiving antenna 3 includes four antenna elements 3a, 3b, 3c, and 3d disposed along the Y-axis direction). That is, the transmitting antenna 2 and the receiving antenna 3 are each made as a phased array antenna, which changes the transmitting direction (and receiving direction) of the electromagnetic waves by electronic scanning.

For example, a patch antenna having the directivity characteristics in the direction normal to the board surface is applied as the antenna elements 2a to 2d included in the transmitting antenna 2 and the antenna elements 3a to 3d included in the receiving antenna 3. The antenna having the directivity characteristics in the direction normal to the board surface like the patch antenna can include many antenna elements on the board surface. This makes it possible to obtain high gain (in this embodiment, for the sake of convenience in describing, only the antenna elements 2a to 2d and 3a to 3d are illustrated).

Note that the transmitting antenna 2 and the receiving antenna 3 may be any antenna composed of a conductor pattern formed on the circuit board 1, and a slot antenna or the like may also be applied.

Hereinafter, the transmitting antenna 2 and the receiving antenna 3 are also collectively called an "antenna unit." The transmitting antenna 2 and the receiving antenna 3 may be composed of an antenna shared for transmitting and receiving the electromagnetic waves.

The electromagnetic waves transmitted upward by the transmitting antenna 2 are reflected by the reflection unit 8 and their traveling direction is changed to the front direction. The electromagnetic waves reflected by the reflection unit 8 are then transmitted toward the dielectric lens 7, converted to plane waves by the dielectric lens 7, and transmitted to the front side outside the radar device U (here, in substantially horizontal direction).

The returning waves reflected by the target outside the device are collected by the dielectric lens 7 and transmitted toward the reflection unit 8. The traveling direction of the reflected waves reflected by the reflection unit 8 is then changed to a direction toward the receiving antenna 3 of the circuit board 1.

Each signal processing IC 4 (corresponding to a "signal processing unit" of the present disclosure) performs transmission and reception of an electric signal between the transmitting antenna 2 and the receiving antenna 3, allows the transmitting antenna 2 to transmit the electromagnetic waves, and receives and processes the reflected waves received by the receiving antenna 3.

For example, the signal processing IC 4 is composed mainly of a known microcomputer including a CPU, a ROM, a RAM, and so on, and also includes an oscillator and a signal processing circuit and the like for transmission and reception processing. Note that, part of the signal processing IC 4 may be implemented only with dedicated hardware without CPU or the like, and part of the processing of the signal processing IC 4 may be executed by external equipment such as a vehicle ECU.

In Fig. 3, as an example of the signal processing IC 4, a signal processing IC that performs signal processing relating to millimeter-wave bands for the transmitting antenna 2, a signal processing IC that performs signal processing relating to millimeter-wave bands for the receiving antenna 3, and a signal processing IC that performs signal processing relating to a baseband band are illustrated as individual chips.

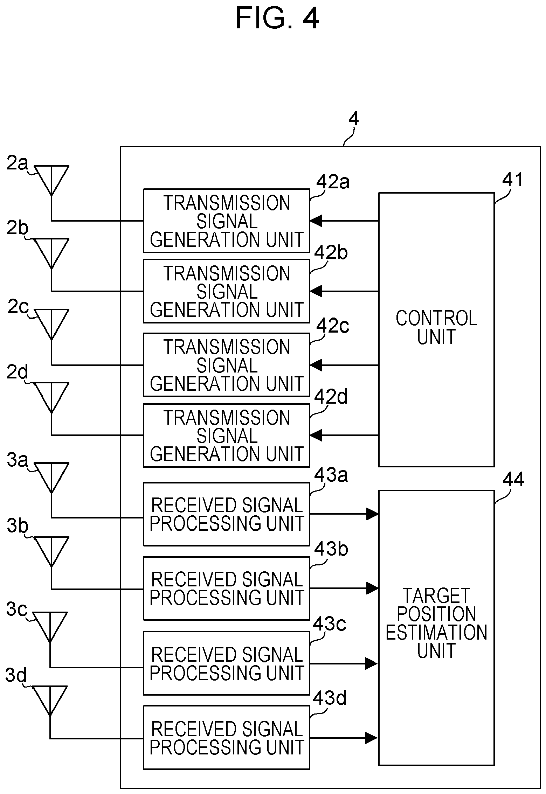

Fig. 4 is a block diagram illustrating a configuration of the signal processing IC 4 of the radar device U according to this embodiment.

The signal processing IC 4 according to this embodiment typically includes the radar device U of the frequency modulated continuous wave (FM-CW) system. However, the radar device U may be of the pulse radar system.

For example, the signal processing IC 4 includes a control unit 41, transmission signal generation units 42a to 42d individually connected to the corresponding antenna elements 2a to 2d of the transmitting antenna 2, received signal processing units 43a to 43d individually connected to the corresponding antenna elements 3a to 3d of the receiving antenna 3, and a target position estimation unit 44 for obtaining received signals corresponding to the reflected waves from the target which are respectively received and processed by the received signal processing units 43a to 43d.

For example, the control unit 41 controls operations of the transmission signal generation units 42a to 42d and controls the direction of the electromagnetic waves transmitted from the radar device U to outside of the device by the electronic scanning. For example, the transmission signal generation units 42a to 42d use reference signals obtained from the oscillator to sequentially generate high-frequency (e.g., millimeter-wave frequency band) transmission signals, which is frequency-modulated such that the frequency temporally repeats gradual increase and gradual decrease. Based on the transmission signals, the transmission signal generation units 42a to 42d then transmit the transmission signals to the antenna elements 2a to 2d respectively connected to themselves and allow the antenna elements 2a to 2d respectively connected to themselves to transmit the frequency-modulated electromagnetic waves. The transmission signal generation units 42a to 42d change the direction of the electromagnetic waves transmitted from the radar device U to outside of the device (i.e., a combined wave of the electromagnetic waves transmitted from the antenna elements 2a to 2d) by respectively adjusting the phase of the electromagnetic waves transmitted from the antenna elements 2a to 2d.

For example, the received signal processing units 43a to 43d use local signals generated by the transmission signal generation units 42a to 42d to perform quadrature detection processing, frequency analysis processing, and the like on the received signals corresponding to the reflected waves obtained from the antenna elements 3a to 3d respectively connected to the received signal processing units 43a to 43d themselves.

The target position estimation unit 44 obtains the received signals corresponding to the reflected waves from the target which are respectively received and processed by the received signal processing units 43a to 43d and calculates phase differences of the reflected waves received by the antenna elements 3a to 3d to estimate the azimuth of the target. At that time, the target position estimation unit 44 may detect a distance to the target, a relative speed, and the like.

As described above, the estimation of the azimuth of the object detection by the electronic scanning makes it possible to further improve the resolution capability of the azimuth estimation comparing with the object detection using an antenna having a fixed directivity like the related-art technique in PTL 1.

Since the processing performed by the signal processing IC 4 is similar to that of a known configuration, detailed descriptions thereof are omitted.

The connector 5 communicably connects the signal processing ICs 4 and the external equipment (e.g., vehicle ECU mounted in vehicle C).

The housing 6 houses the circuit board 1, supports the dielectric lens 7 in front of the circuit board 1, and supports the reflection unit 8 above the circuit board 1. The housing 6 and the dielectric lens 7 are combined with each other, and the circuit board 1 is housed in the housing 6 and the dielectric lens 7 in a substantially sealed state, for example.

From the viewpoints of miniaturization, an outer shape of the housing 6 is a shape following an outer shape of the circuit board 1 (e.g., rectangular parallelepiped shape) and the housing 6 has a length in the Z direction shorter than a length in the X direction, for example. The length in the Z direction of the housing 6 is, for example, set as a length that is the sum of an aperture length and a predetermined margin width, with which desirable gain is obtained when transmitting and receiving the electromagnetic waves.

From the viewpoints of preventing the reflected waves from the cover member B from entering the housing 6, improving characteristics of dissipating heat from the circuit board 1, improving EMC characteristics, and the like, a metal member (e.g., aluminum material) is used as material of the housing 6, for example. However, when considering more about cost and weight saving, resin may be used as the material of the housing 6, or the housing 6 and the dielectric lens 7 may be integrally formed of an identical resin material. Note that, the material of the housing 6 preferably includes material with higher thermal conductivity than the dielectric lens 7.

On a front surface of the housing 6, an aperture 6a (e.g., an aperture having substantially the same size as a beam width of the electromagnetic waves transmitted by the transmitting antenna 2) for transmitting and receiving the electromagnetic waves to and from the transmitting antenna 2 and the receiving antenna 3 is formed. The dielectric lens 7 is fitted to the aperture 6a.

The reflection unit 8 reflects the electromagnetic waves transmitted upward from the transmitting antenna 2, changes the traveling direction of the electromagnetic waves to the front direction, and transmits the electromagnetic waves in the front direction, while changing the traveling direction of the reflected waves from the front direction to a direction toward the board surface of the circuit board 1 and transmitting the reflected wave to the receiving antenna 3. That is, the radar device U according to this embodiment achieves a radar device mounted in a lateral direction by providing the reflection unit 8.

The reflection unit 8 is, for example, supported at an inner wall surface of the housing 6 and disposed above the board surface of the circuit board 1 so as to cover the transmitting antenna 2 and the receiving antenna 3. The region in which the reflection unit 8 is disposed is not necessarily the entire upper surface of the housing 6 and may be set to cover only front side from the transmitting antenna 2 and the receiving antenna 3.

A shape of a reflection surface of the reflection unit 8 is typically a mirror polished flat surface or curved surface. The reflection surface of the reflection unit 8 may be formed substantially parallel to the board surface of the circuit board 1 or formed to have an inclination angle. In Fig. 2, the reflection unit 8 is disposed such that the reflection surface is inclined 45 degrees to the board surface of the circuit board 1.

Material of the reflection unit 8 may be typically a metal member and integrally formed with the walls of the housing 6. The reflection unit 8 may be a resin member with a surface coated with metal plating.

The dielectric lens 7 is supported in front of the circuit board 1, narrows a beam of the electromagnetic waves (i.e., transmission waves) from the reflection unit 8, and emits the electromagnetic waves to the front region outside the device. The dielectric lens 7 then collects the reflected waves, which are the transmitted electromagnetic waves returning back from the target, into the reflection unit 8.

The dielectric lens 7 increases gain of the transmission and reception of the electromagnetic waves by the transmitting antenna 2 and the receiving antenna 3 and also functions as a radome that protects the transmitting antenna 2 and the receiving antenna 3. The dielectric lens 7 also inhibits the reflected waves from the cover member B from entering the receiving antenna 3.

For the dielectric lens 7 according to this embodiment, a lens having a semi-cylindrical shape or a parabolic-cylindrical shape that projects in the positive X direction and extends along the Y-axis direction (i.e., a direction of the arrays of the antenna elements 2a to 2d and 3a to 3d) is used.

A side section of the dielectric lens 7 having the semi-cylindrical shape or the parabolic-cylindrical shape has substantially the same shape at any positions in the Y-axis direction (this shape is also referred to as a barrel vault shape). This makes it possible to inhibit the electromagnetic waves respectively transmitted from the multiple antenna elements 2a to 2d of the transmitting antenna 2 disposed along the Y-axis direction from being directed in different directions when being reflected at the target and arriving at the receiving antenna 3 (see Fig. 3). This inhibits deterioration of object detection accuracy caused by the mutual interference of the reflected waves or change of the phase differences.

Material of the dielectric lens 7 may be selected as desired, and, for example, acrylic resin, tetrafluoroethylene resin, polystyrene resin, polycarbonate resin, polybutylene terephthalate resin, polyphenylene resin, polypropylene resin, syndiotactic polystyrene resin, ABS resin, or the like is used as the material.

### [Effect]

As described above, the radar device U according to this embodiment includes the antenna units 2 and 3 (typically, the phased array antennas including multiple patch antennas) including multiple antenna elements 2a to 2d and 3a to 3d arrayed along a direction intersecting the front direction in the circuit board 1 extending along the front direction, the reflection unit 8 supported above the board surface of the circuit board 1 in the housing 6, and the dielectric lens 7, which has the semi-cylindrical shape or the parabolic-cylindrical shape projecting in the front direction and which is mounted to extend along the direction of the arrays of the multiple antenna elements 2a to 2d and 3a to 3d in the aperture 6a of the housing 6.

Thus, according to the radar device U of this embodiment, the radar device U can have a device configuration of being mounted in a lateral direction, increase the antenna gain, and improve the resolution capability of the azimuth estimation. Since the dielectric lens 7 having the semi-cylindrical shape is applied, deterioration of the radar performance due to mutual interference of the reflected waves of the electromagnetic waves transmitted from the multiple antenna elements 2a to 2d is also inhibited.

According to the radar device U of this embodiment, since the dielectric lens 7 can also function as a radome, it is possible to make the antenna units 2 and 3 waterproof and protect them from a flying object without providing a separate radome. Accordingly, it is also possible to make the antenna aperture surface smaller than that in a case of providing the separate radome.

According to the radar device U of this embodiment, it is possible to reflect the electromagnetic waves reflected at the dielectric lens 7 in a direction away from the antenna units 2 and 3 even when the electromagnetic waves transmitted from the antenna units 2 and 3 are reflected at the cover member B. Also, the device mounted in a lateral direction makes it possible to limit a region (i.e., the aperture 6a) into which the reflected waves from the cover member B may enter the housing 6. Thus, it is possible to inhibit the deterioration of the object detection accuracy caused by the reflected waves from the cover member B.

### (Second Embodiment)

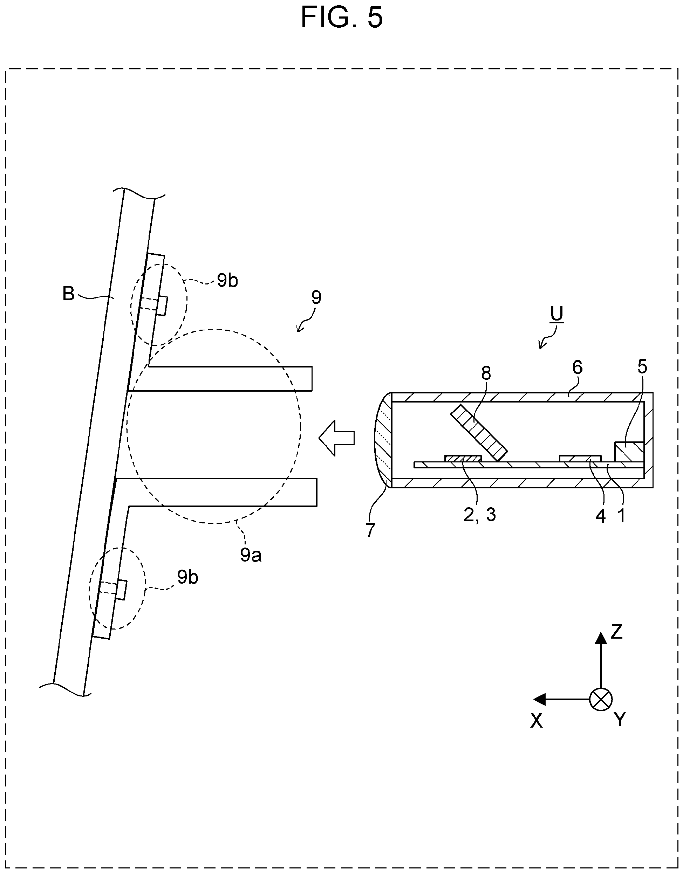

Next, an example of a configuration of a radar device U according to a second embodiment is described with reference to Fig. 5.

Fig. 5 is a side sectional view of the radar device U according to the second embodiment.

The radar device U according to this embodiment is different from the radar device U according to the first embodiment in that the radar device U according to this embodiment has a bracket 9 for fixing the housing 6 and the like to the cover member B. Descriptions of configurations common to the first embodiment are omitted (the same applies hereinafter for other embodiments).

The bracket 9 holds the housing 6 with respect to the cover member B and defines the direction in which the radar device U transmits and receives the electromagnetic waves.

The bracket 9 has, for example, a storage part 9a that stores the radar device U and fixing parts 9b that are fixed to the cover member B.

For example, the storage part 9a is in a cylindrical shape that allows the housing 6 to be inserted therein from the front surface (i.e., surface on which the dielectric lens 7 is mounted) of the housing and forms a space for storage following the outer shape of the housing 6. The storage part 9a has an aperture in the region where the dielectric lens 7 on the front surface of the radar device U is disposed so that the radar device U transmits and receives the electromagnetic waves.

The fixing parts 9b are parts to be fixed to the cover member B with a double-sided tape, bolts, and so on. A method of fixing the fixing parts 9b to the cover member B is not limited and ultrasonic welding or the like may also be used.

With the above configuration, the bracket 9 fixes the housing 6 to the cover member B such that the direction in which the electromagnetic waves are transmitted and received by the radar device U is parallel to the ground, for example. This enables the object detection for the target existing around the vehicle C.

The bracket 9 may include an adjustment mechanism (e.g., using pin joint and fixing pin) that can change the angle of the transmitting and receiving direction of the electromagnetic waves. Using such adjustment mechanism enables fine adjustment of the transmitting and receiving direction of the electromagnetic waves.

As described above, according to the radar device U of this embodiment, it is possible to transmit and receive the electromagnetic waves in a desirable direction (e.g., direction parallel to the ground) while mechanical stability being secured.

### (Third Embodiment)

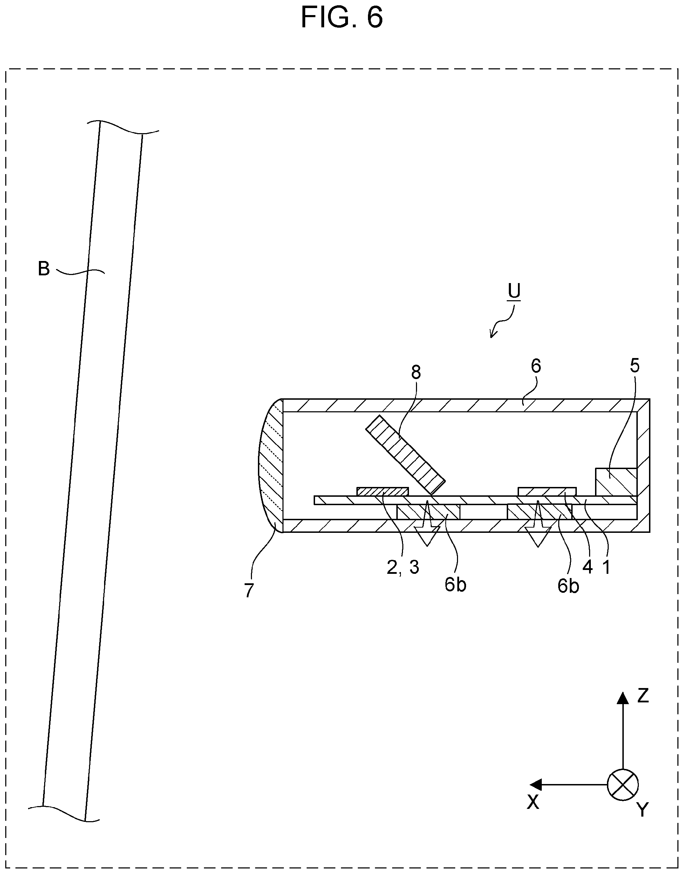

Next, an example of a configuration of a radar device U according to a third embodiment is described with reference to Fig. 6.

Fig. 6 is a side sectional view of the radar device U according to the third embodiment.

The radar device U according to this embodiment is different from the radar device U according to the first embodiment in that the housing 6 has connection units 6b that are thermally bonded to the circuit board 1 or circuit parts (e.g., signal processing ICs 4) mounted on the circuit board 1.

Fig. 6 illustrates a state where the connection units 6b thermally bond the wall of the housing 6 and the circuit board 1. White arrows in Fig. 6 represent heat flows from the circuit board 1.

In this embodiment, a metal member with high heat dissipation characteristics is used as the material of the housing 6, for example. The connection units 6b then thermally bond the wall of the housing 6 and the circuit board 1 or the circuit parts mounted on that circuit board 1.

The configuration of the connection units 6b is not limited; for example, the connection units 6b may be integrally formed with the wall of the housing 6 or may be made of silicone grease or an adhesive such as epoxy resin. Otherwise, the connection units 6b may be members in a form of putty, rubber, gel, or a compound.

Since the entire region of the housing 6 except the front surface is a wall region that can dissipate heat, the radar device U according to this embodiment can acquire a wide wall region of the housing 6 that can dissipate heat.

As described above, according to the radar device U of this embodiment, it is possible to improve the heat dissipation characteristics of the circuit board 1 and the like.

### (Fourth Embodiment)

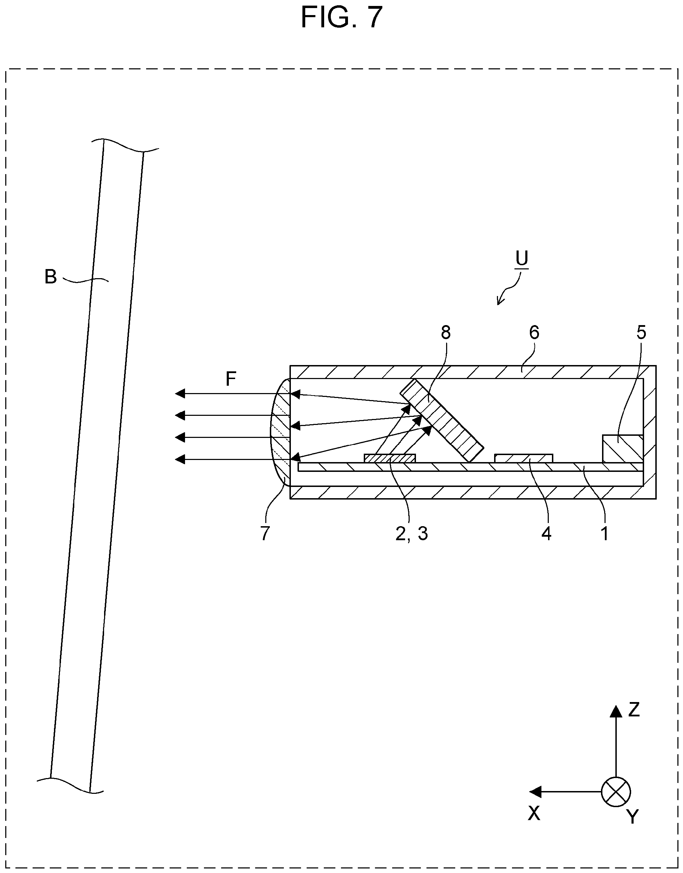

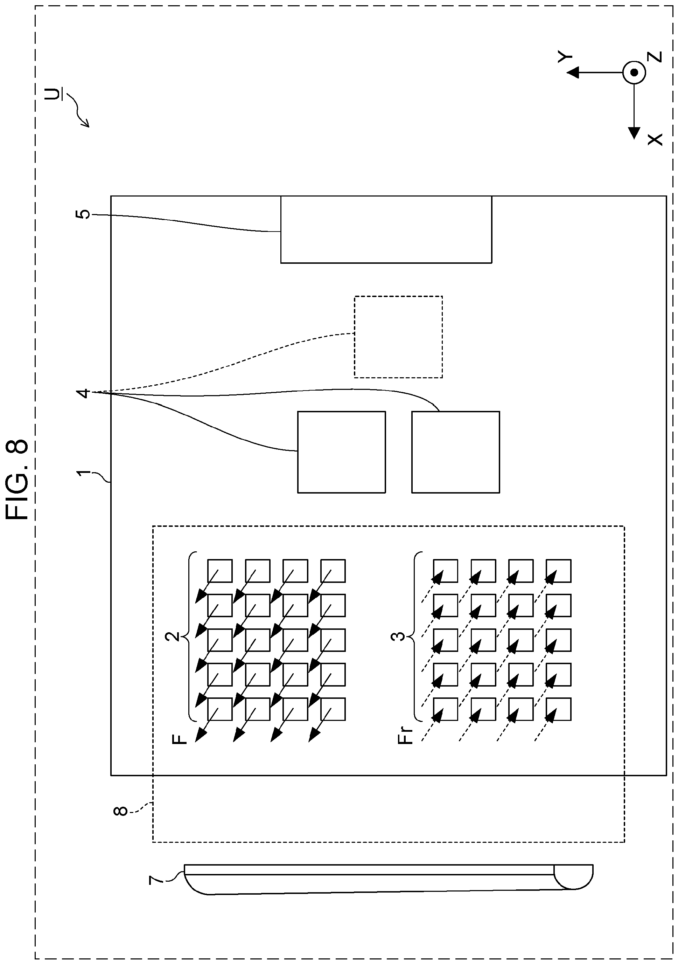

Next, an example of a configuration of a radar device U according to a fourth embodiment is described with reference to Figs. 7 and 8.

Fig. 7 is a side sectional view of the radar device U according to the fourth embodiment. Fig. 8 is a view of the radar device U according to the fourth embodiment seen from above.

The radar device U according to this embodiment is different from the radar device U according to the first embodiment in the configuration of the antenna units 2 and 3 and the configuration of the reflection unit 8.

The reflection unit 8 according to this embodiment is disposed such that the reflection surface is inclined in the positive Z direction with respect to the board surface of the circuit board 1.

The direction of the electromagnetic waves of the transmitting antenna 2 and the receiving antenna 3 according to this embodiment is inclined from above the board surface of the circuit board 1 to the rear direction (negative X direction). The transmitting antenna 2 and the receiving antenna 3 according to this embodiment include multiple antenna elements arrayed in matrix along the Y-axis direction and the X-axis direction. The directions of the electromagnetic waves transmitted from the antenna elements are adjusted according to the positional relationships between the reflection unit 8 and the antenna elements.

With the above configuration, the radar device U according to this embodiment can change the traveling direction of the electromagnetic waves transmitted from the transmitting antenna 2 to a substantially positive X direction using the reflection unit 8 regardless of the positions of the antenna elements included in the transmitting antenna 2 (or the receiving antenna 3). The configuration of the radar device U according to this embodiment is particularly useful when the number of the antenna elements is large.

### (Fifth Embodiment)

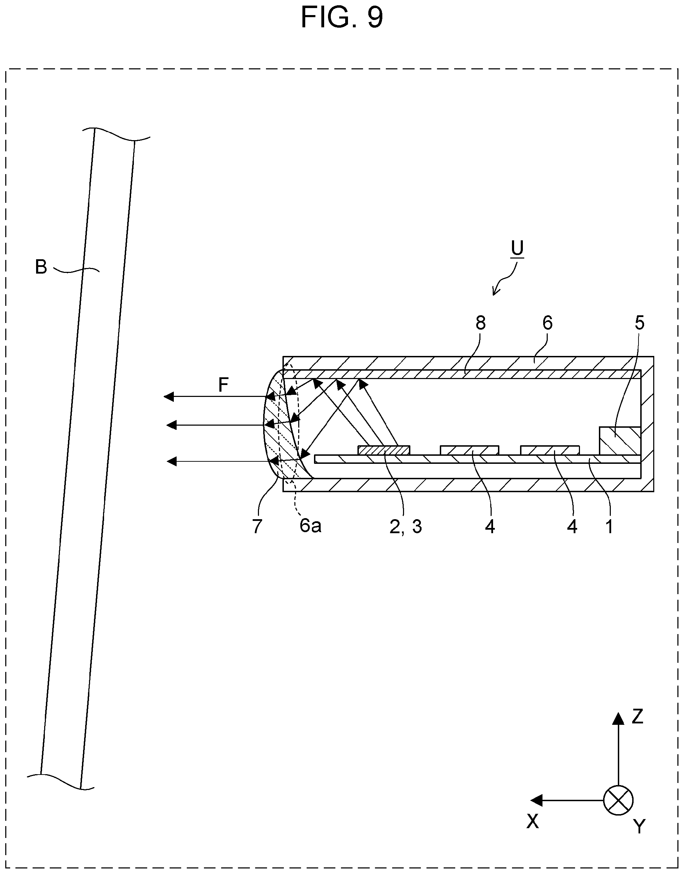

Next, an example of a configuration of a radar device U according to a fifth embodiment is described with reference to Fig. 9.

Fig. 9 is a side sectional view of the radar device U according to the fifth embodiment.

The radar device U according to this embodiment is different from the radar device U according to the fourth embodiment in the configurations of the dielectric lens 7 and the reflection unit 8.

The reflection unit 8 according to this embodiment is composed of a reflection plate having the reflection surface substantially parallel to the circuit board 1.

The dielectric lens 7 according to this embodiment has the semi-cylindrical shape having a refractive index which increases toward a lower side thereof.

With the above configuration, the radar device U according to this embodiment can change the traveling direction of the electromagnetic waves transmitted from the transmitting antenna 2 to a substantially positive X direction using the reflection unit 8 regardless of the positions of the antenna elements included in the transmitting antenna 2 (or the receiving antenna 3). The configuration of the radar device U according to this embodiment is particularly useful when the number of the antenna elements is large as illustrated in Fig. 8.

### (Sixth Embodiment)

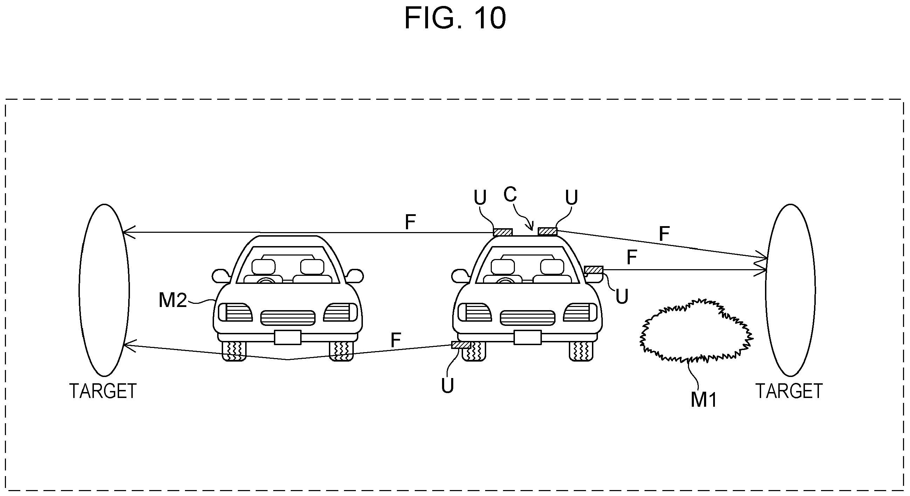

Fig. 10 is a diagram illustrating an example of a position at which a radar device U according to a sixth embodiment is mounted.

The radar device U according to this embodiment is different from the radar device U according to the first embodiment in that the radar device U according to this embodiment is mounted on a vehicle body top of the vehicle C, on a vehicle body bottom of the vehicle C, or on a side mirror of the vehicle C. In Fig. 10, four radar devices U are mounted.

Radars according to the related art have been required to be mounted within a bumper so that the appearance of the vehicle is not affected, and the height at which the radars are mounted has been limited to around 30 to 60 cm. Because of this, transmission of the electromagnetic waves may be blocked by an obstacle around the vehicle and thus the area to be detected may be limited.

In this regard, since the radar device U according to this disclosure is mounted in a lateral direction, thus occupies less space in the top-bottom direction, and becomes less apparent from the outside. Thus, in this embodiment, the radar device U is mounted on the vehicle body top of the vehicle C or on the vehicle body bottom of the vehicle C.

The radar device U mounted on the vehicle body top of the vehicle C can transmit the electromagnetic waves to a distant area without being blocked by an object M1 (e.g., hedge) disposed on the road. That is, the radar device U mounted on the vehicle body top makes it possible to detect the target (e.g., person or vehicle) beyond the object M. The similar effect may be expected for the radar device U mounted on the side mirror of the vehicle C.

The radar device U mounted on the vehicle body bottom of the vehicle C can transmit the electromagnetic waves to a distant area without being blocked by another vehicle M2 by transmitting the electromagnetic waves so that the electromagnetic waves pass through a space between a vehicle body of the other vehicle M2 and the road. That is, the radar device U mounted on the vehicle body bottom makes it possible to detect the target (e.g., person or vehicle) beyond the other vehicle M2.

As described above, according to the radar device U of this embodiment, it is possible to transmit the electromagnetic waves without being blocked by another object. This makes it possible to improve the SNR and detection of a target in a distant area.

### (Seventh Embodiment)

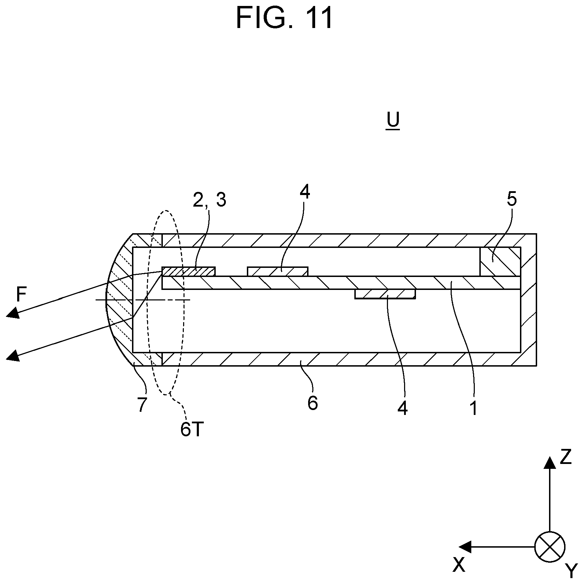

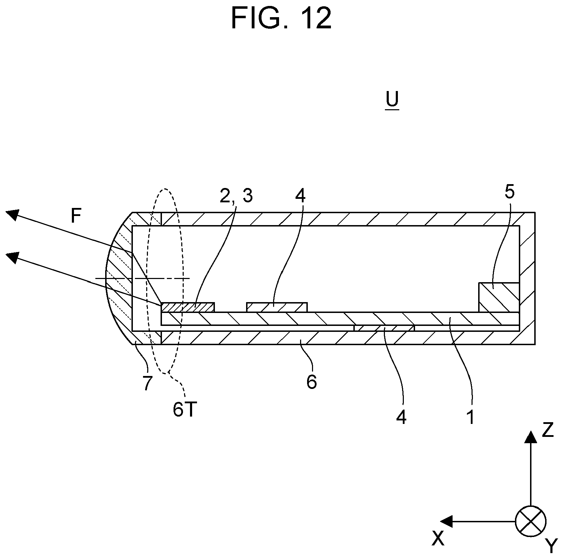

Figs. 11 and 12 are side sectional views illustrating an example of a configuration of a radar device U according to a seventh embodiment.

The radar device U according to this embodiment is different from the radar device U according to the first embodiment in that the direction of the electromagnetic waves transmitted from the antenna unit (transmitting antenna 2 and receiving antenna 3) is tilted from the X-axis direction of the extending direction of the circuit board 1 (i.e., the extending direction of the housing 6) in the radar device U according to this embodiment.

Fig. 11 illustrates an aspect where the antenna unit (transmitting antenna 2 and receiving antenna 3) is disposed at a position deviated from the optical axis of the dielectric lens 7 in the upward direction in the housing 6 and the antenna unit transmits the electromagnetic waves in the direction tilted downward from the extending direction of the circuit board 1. Fig. 12 illustrates an aspect where the antenna unit (transmitting antenna 2 and receiving antenna 3) is disposed at a position deviated from the optical axis of the dielectric lens 7 in the downward direction in the housing 6 and the antenna unit transmits the electromagnetic waves in the direction tilted upward from the extending direction of the circuit board 1.

That is, with such aspects, the direction of transmitting the electromagnetic waves is tilted upward or downward from the extending direction of the housing 6.

The radar device U according to this embodiment is particularly preferable for the aspect described in the sixth embodiment (Fig. 10). That is, when the radar device U is mounted on the vehicle body top of the vehicle C, it is possible to make a top-down field of view without changing the orientation of the housing 6 by changing the direction of transmitting the electromagnetic waves downward as illustrated in Fig. 11. When the radar device U is mounted on the vehicle body bottom of the vehicle C, it is possible to inhibit reflection of the electromagnetic waves at the road by changing the direction of transmitting the electromagnetic waves upward as illustrated in Fig. 12.

The dielectric lens 7 according to this embodiment may be a dielectric lens in which the direction of the optical axis is tilted from the extending direction of the circuit board 1 or a dielectric lens in which the upper side and the lower side of the optical axis have different refractive indexes.

### (Other Embodiments)

The present disclosure is not limited to the above-described embodiments and various modifications can be considered. For example, various combinations of the aspects described in those embodiments may be used.

In the above-described embodiments, an aspect where the radar device U is disposed in the bumper B of a vehicle is described as an example of an aspect where the radar device U is preferably applied. However, the target for which the radar device U according to the present disclosure is used is not limited thereto, and the radar device U may also be used for a rotary wing machine (e.g., helicopter), a robot, or the like.

Although specific examples of the present disclosure are described in detail, these are merely examples and do not intend to limit the scope of claims. The techniques described in the scope of claims include various modifications and changes of the specific examples described above.

The present disclosure can be realized by software, hardware, or software in cooperation with hardware.

Each functional block used in the description of each embodiment described above can be partly or entirely realized by an LSI such as an integrated circuit, and each process described in each embodiment may be controlled partly or entirely by the same LSI or a combination of LSIs. The LSI may be individually formed as chips, or one chip may be formed so as to include a part or all of the functional blocks. The LSI may include a data input and output coupled thereto. The LSI here may be referred to as an IC, a system LSI, a super LSI, or an ultra LSI depending on a difference in the degree of integration.

However, the technique of implementing an integrated circuit is not limited to the LSI and may be realized by using a dedicated circuit, a general-purpose processor, or a special-purpose processor. In addition, a FPGA (Field Programmable Gate Array) that can be programmed after the manufacture of the LSI or a reconfigurable processor in which the connections and the settings of circuit cells disposed inside the LSI can be reconfigured may be used. The present disclosure can be realized as digital processing or analogue processing.

If future integrated circuit technology replaces LSIs as a result of the advancement of semiconductor technology or other derivative technology, the functional blocks could be integrated using the future integrated circuit technology. Biotechnology can also be applied.

According to the radar device of the present disclosure, the radar device can have a horizontal device configuration and achieve high antenna gain and high azimuth resolution capability.

## Claims

1. A radar device, comprising:
a housing that includes an aperture in a front direction as a transmitting direction of an electromagnetic wave;
a circuit board that is disposed in the housing such that a board surface extends along the front direction;
an antenna unit that includes two or more antenna elements being arrayed along a direction intersecting the front direction in the circuit board, and that transmits the electromagnetic wave upward of the board surface of the circuit board and receives a reflected wave of the electromagnetic wave;
a reflection unit that is supported in the housing above the board surface of the circuit board and that reflects the electromagnetic wave transmitted from the antenna unit to change a traveling direction of the electromagnetic wave to the front direction and reflects the reflected wave from the front direction to change a traveling direction of the reflected wave to a direction toward the antenna unit; and
a dielectric lens that is disposed in the aperture of the housing to extend along a direction in which the two or more antenna elements are arrayed, and that has a semi-cylindrical shape or a parabolic-cylindrical shape projecting in the front direction.

2. The radar device according to Claim 1, wherein
each of the two or more antenna elements is composed of a conductor pattern formed on the board surface of the circuit board.

3. The radar device according to Claim 2, wherein
each of the two or more antenna elements is a patch antenna.

4. The radar device according to Claim 1, further comprising
a signal processing unit that controls a phase of the electromagnetic wave transmitted from each of the two or more antenna elements and changes the transmitting direction of the electromagnetic wave transmitted to outside of the housing.

5. The radar device according to Claim 1, wherein
based on a front-rear direction corresponding to the transmitting direction of the electromagnetic wave and a top-bottom direction corresponding to a direction normal to the board surface of the circuit board,
a length in the front-rear direction of the housing is longer than a length in the top-bottom direction of the housing.

6. The radar device according to Claim 1, wherein
the housing includes a connection unit that is thermally bonded to the circuit board or a circuit part mounted on the circuit board.

7. The radar device according to Claim 1, wherein
the electromagnetic wave is transmitted through a cover member disposed to cover a region in the front direction of the housing.

8. The radar device according to Claim 1, wherein
the radar device is supported such that the front direction as the transmitting direction of the electromagnetic wave is parallel to the ground.

9. The radar device according to Claim 1, wherein
based on an upward direction and a downward direction orthogonal to an extending direction of the circuit board,
the antenna unit is disposed at a position deviated from an optical axis of the dielectric lens in the upward direction in the housing and transmits the electromagnetic wave in the transmitting direction being tilted to the downward direction from the extending direction of the circuit board.

10. The radar device according to Claim 1, wherein
based on an upward direction and a downward direction orthogonal to an extending direction of the circuit board,
the antenna unit is disposed at a position deviated from an optical axis of the dielectric lens in the downward direction in the housing and transmits the electromagnetic wave in the transmitting direction being tilted to the upward direction from the extending direction of the circuit board.

11. The radar device according to Claim 1 mounted in a vehicle.

12. The radar device according to Claim 11 mounted on a vehicle body top of the vehicle.

13. The radar device according to Claim 11 mounted on a vehicle body bottom of the vehicle.
